**Europäisches Patentamt**

**European Patent Office**

**Office européen des brevets**

(19)

(11) Veröffentlichungsnummer : **0 069 896**
**B1**

# EUROPÄISCHE PATENTSCHRIFT

(12)

(45) Veröffentlichungstag der Patentschrift :
**15.05.85**

(21) Anmeldenummer : **82105633.0**

(22) Anmeldetag : **25.06.82**

(51) Int. Cl.⁴ : **H 01 B 12/00**, H 01 L 39/24

(54) **Verfahren zur Herstellung eines supraleitenden Hohlleiters.**

(30) Priorität : **10.07.81 DE 3127292**

(43) Veröffentlichungstag der Anmeldung :
**19.01.83 Patentblatt 83/03**

(45) Bekanntmachung des Hinweises auf die Patenterteilung : **15.05.85 Patentblatt 85/20**

(84) Benannte Vertragsstaaten :
**CH DE FR GB LI**

(56) Entgegenhaltungen :
**DE-A- 1 935 049**
**DE-B- 2 111 515**
**DE-B- 2 311 875**

(73) Patentinhaber : **VACUUMSCHMELZE GMBH**
**Grüner Weg 37**
**D-6450 Hanau 1 (DE)**

(72) Erfinder : **Hillmann, Hans, Dr.**
**Würzburger Strasse 55**
**D-6458 Rodenbach (DE)**

## Beschreibung

Die Erfindung betrifft ein Verfahren zur Herstellung einer Leiteranordnung aus supraleitfähigen Leitersträngen, bei der die wendelförmig gewickelten Leiterstränge unmittelbar an der Innenwand anliegend innerhalb eines rohrförmigen Trägerkörpers angeordnet werden.

Aus der DE-OS 19 40 147 ist eine Leiteranordnung aus mehreren Leiterstreifen für supraleitende Kabel bekannt, bei denen die Leiterstränge wendelförmig im Innern eines rohrförmigen Trägerkörpers angeordnet sind.

Aus der DE-OS 19 35 049 ist es bekannt, einen rohrförmigen Trägerkörper aus Kunststoff vorzusehen. Wendelförmig gebogene Supraleiter werden unter anderen mit einem rohrförmigen Trägerkörper aus einem Isoliermaterial durch Aufextrudieren auf die Leiterstränge, wo mit diesem innig verbunden.

Weiterhin ist es aus der DE-AS 23 11 875 bekannt, Supraleiter einer querschnittsverringernden Verformung zu unterziehen, und die DE-AS 21 11 515 zeigt ein supraleitendes Kabel, das innerhalb und außerhalb der Isolation mit einem zu einer einlagigen Wendel gewickelten Band versehen ist.

Aufgabe der vorliegenden Erfindung ist es, ein Verfahren zur Herstellung eines supraleitenden Hohlleiters anzugeben, mit dem sich auf einfache Weise große Leiterlängen herstellen lassen und mit dem man eine mechanisch stabile und besonders gut kühlbare Leiteranordnung erhält.

Das Verfahren zur Herstellung einer Leiteranordnung aus supraleitfähigen Leitersträngen, bei der die wendelförmig gewickelten Leiterstränge unmittelbar an der Innenwand anliegend innerhalb eines rohrförmigen Trägerkörpers angeordnet werden besteht erfindungsgemäß darin, daß anschließend der rohrförmige Trägerkörper durch Walzen oder Ziehen zu einem Rohr mit geringerem Innendruchmesser im Vergleich zum ursprünglichen Außendurchmesser der wendelförmigen Leiterstränge verformt wird.

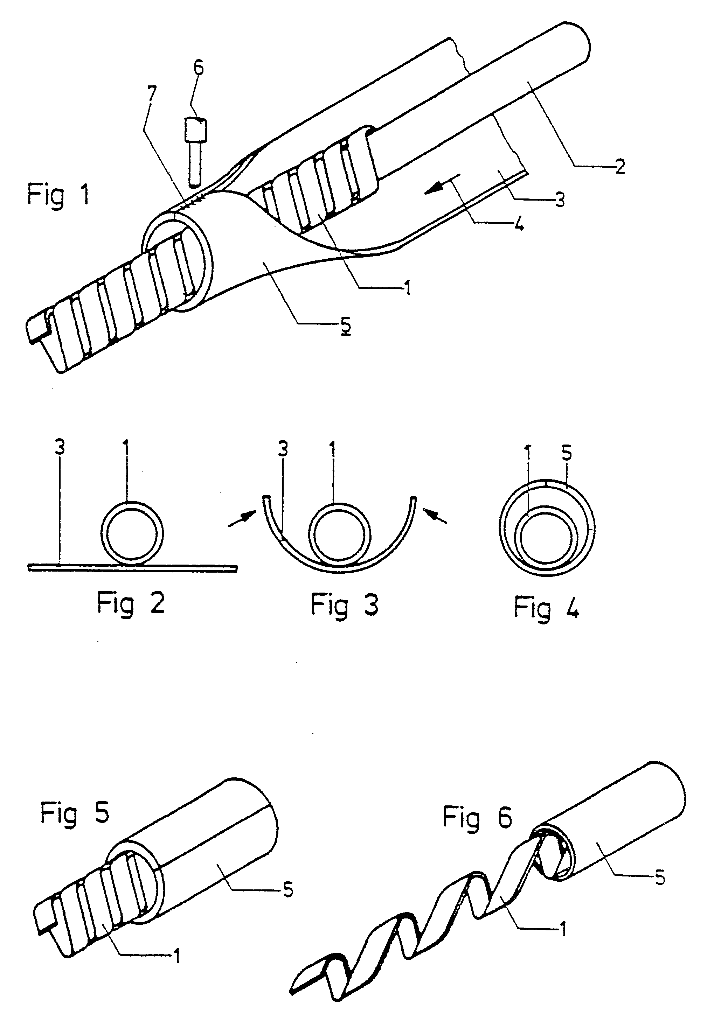

Ein besonders vorteilhaftes Ausführungsbeispiel ist in den Figuren 1 bis 6 dargestellt.

Figur 1 zeigt die Leiteranordnung während der Herstellung in perspektivischer Ansicht. Hierbei sind Werkzeuge zur Herstellung des rohrförmigen Trägerkörpers und der wendelförmigen Leiterstränge nicht dargestellt.

Die Leiterstränge 1 werden um einen Dorn 2 herumgewickelt. Dies geschieht beispielsweise durch Festhalten eines Endes des Leiterstranges 1 am Dornumfang und durch Drehen des Dornes 2. Unterhalb des Dornes 2 mit der darauf gewickelten Wendel aus dem Leiterstrang 1 befindet sich ein Blech 3, das beispielsweise aus Stabilisierungsmetall für den Supraleiter besteht, aber auch zur Erreichung einer guten mechanischen Festigkeit aus Stahl oder einer anderen Legierung mit höherer Festigkeit sein kann. Gute Eigenschaften erreicht man bei Verwendung eines Bleches 3 aus einem Stahl-Kupfer-Verbundmaterial, das an der dem Dorn 2 zugewandten Oberfläche mit einer Lötfolie beschichtet sein kann.

Das Blech 3 wird zusammen mit der gewickelten Wendel in Richtung des Pfeiles 4 fortbewegt und dabei durch Ziehen, Walzen oder dergleichen zu einem rohrförmigen Trägerkörper 5 verformt. An der Stelle, wo sich die beiden Seiten des Bleches 3 berühren, werden diese mit Hilfe einer Schweißelektrode 6 miteinander verschweißt.

Die Figuren 2 bis 4 zeigen verschiedene Stadien bei der Formung des Bleches 3 zum rohrförmigen Trägerkörper 5. Hieraus geht hervor, daß die wendelförmigen Leiterstränge 1 in der Mitte des Bleches 3 aufliegen (Fig. 2), daß das Blech 3 dann halbkreisförmig nach oben gebogen (Fig. 3) und daß dieser Halbkreis anschließend zu einem vollständigen Kreis und damit zum vollständigen Trägerkörper 5 (Fig. 4) wird. Der Innendurchmesser des Trägerkörpers 5 ist dabei größer als der Außendurchmesser der wendelförmigen Leiterstränge 1, so daß die Schweißnaht 7 von den Leitersträngen 1 entfernt ist und so durch das Schweißen eine unzulässige Erwärmung der Leiterstränge 1 vermieden wird.

Figur 5 zeigt den rohrförmigen Trägerkörper 5 mit den innenliegenden wendelförmigen Leitersträngen 1, nachdem durch Ziehen oder Walzen der Trägerkörper 5 auf einen Innendurchmesser verringert ist, der dem Außendurchmesser der wendelförmigen Leiterstränge 1 entspricht.

Durch weiteres Ziehen oder Walzen wird anschließend oder im gleichen Arbeitsgang — wie Figur 6 zeigt — der Durchmesser des rohrförmigen Trägerkörpers 5 bei gleichzeitiger Vergrößerung der Rohrlänge weiter verringert. Die aus den Leitersträngen 1 bestehende Wendel wird dabei ebenfalls gestreckt, indem sich die Steigung der Wendel erhöht, so daß sich größere Zwischenräume zwischen den Windungen der wendelförmigen Leiterstränge ergeben. Diese größeren Zwischenräume verbessern die Kühlwirkung durch das im Innern des Trägerkörpers 5 fließende Kühlmittel erheblich.

Obgleich im Ausführungsbeispiel eine eingängige Wendel aus Leitersträngen 1 dargestellt ist, können selbstverständlich auch mehrgängige wendelförmige Leiterstränge 1 Anwendung finden. Außerdem ist es möglich, den in Figur 6 gezeigten Leiter abschnittweise herzustellen, wenn man die wendelförmigen Leiterstränge in ein anderweitig gefertigtes Rohr hineinsteckt und dieses dann durch Walzen oder Ziehen im Durchmesser entsprechend verringert.

Zur besonders sicheren Befestigung der Leiterstränge 1 an der Innenwand des Trägerkörpers 5 kann zwischen den Leitersträngen 1 und dem Trägerkörper 5 eine Lötfolie angeordnet sein und es können die Leiterstränge nach dem Ziehen auf die Endabmessung durch eine Wärmebehandlung mit dem Trägerkörper 5 verlötet werden. Es ist allerdings auch möglich, beispielsweise durch Aufbringung einer Schicht aus elastischem Material auf die Leiterstränge, die Eigenschaften der wendelförmigen Leiterstränge so einzustellen, daß die Leiterstränge federnd an der Innenwand des Trägerkörpers 5 anliegen und so mit diesem in ausreichendem Maß verbunden sind.

**Patentansprüche**

1. Verfahren zur Herstellung einer Leiteranordnung aus supraleitfähigen Leitersträngen, bei der dei wendelförmig gewickelten Leiterstränge (1) unmittelbar an der Innenwand anliegend innerhalb eines rohrförmigen Trägerkörpers (5) angeordnet werden, dadurch gekennzeichnet, daß anschließend der rohrförmige Trägerkörper (5) durch Walzen oder Ziehen zu einem Rohr mit geringerem Innendurchmesser im Vergleich zum ursprünglichen Außendurchmesser der wendelförmigen Leiterstränge (1) verformt wird.

2. Verfahren nach Anspruch 1, dadurch gekennzeichnet, daß zur Herstellung der wendelförmigen Leiterstränge (1) diese über einen Dorn (2) gewickelt werden.

3. Verfahren nach einem der Ansprüche 1 oder 2, dadurch gekennzeichnet, daß zur Anordnung der wendelförmigen Leiterstränge (1) in einem rohrförmigen Trägerkörper (5) dieser durch Biegung eines Bleches (3) zu einem Rohr gebogen und mit einer Schweißnaht (7) die Ränder des Bleches (3) verbunden werden.

4. Verfahren nach Anspruch 1, dadurch gekennzeichnet, daß der rohrförmige Trägerkörper (5) an seiner Innenoberfläche mit einer Lötfolie beschichtet wird und daß nach dem Walzen oder Ziehen des rohrförmigen Trägerkörpers (5) auf seinen Enddurchmesser die Leiterstränge (1) durch Erhitzen an den rohrförmigen Trägerkörper (5) gelötet werden.

5. Verfahren nach Anspruch 1, dadurch gekennzeichnet, daß die Leiterstränge (1) vor Herstellung der Wendel mit einem Metallstreifen verbunden werden, der gut federnde Eigenschaften besitzt.

**Claims**

1. A process for the production of a conductor arrangement, from super-conducting conductor strands, in which the helically wound conductor strands (1) are arranged within a tubular carrier body (5) so as to be directly adjacent to the inner wall, characterised in that by rolling or drawing, the tubular carrier body (5) is subsequently shaped to form a tube having a smaller internal diameter in comparison with the original external diameter of the helical conductor strands (1).

2. A process as claimed in Claim 1, characterised in that, in order to produce the helical conductor strands (1), the latter are wound about a mandrel (2).

3. A process as claimed in one of Claims 1 or 2, characterised in that, in order to arrange the helical conductor strands (1) in a tubular carrier body (5), a sheet (3) is bent to form a tube and the edges of the sheet (3) are connected by a welding seam (7).

4. A process as claimed in Claim 1, characterised in that on its inner surface, the tubular carrier body (5) is covered with a solder film and that, after the rolling or drawing of the tubular carrier body (5) to its final diameter, the conductor strands (1) are soldered to the tubular carrier body (5) by heating.

5. A process as claimed in Claim 1, characterised in that, prior to the production of the helix, the conductor strands (1) are connected to a metal strip which has highly resilient properties.

**Revendications**

1. Procédé pour fabriquer un ensemble conducteur à partir de bandes susceptibles d'être supraconductrices, procédé dans lequel les bandes conductrices (1) enroulées en forme d'hélice, sont disposées directement contre la paroi interne s'appliquant à l'intérieur d'une structure porteuse tubulaire (5), procédé caractérisé en ce que cette structure porteuse tubulaire (5) est ensuite mise en forme par laminage ou étirage pour constituer un tube de diamètre interne plus réduit en comparaison avec le diamètre externe initial des bandes conductrices (1) en forme d'hélice.

2. Procédé selon la revendication 1, caractérisé en ce que, pour la réalisation des bandes conductrices (1) en forme d'hélice, ces bandes sont enroulées sur un mandrin (2).

3. Procédé selon une des revendications 1 ou 2, caractérisé en ce que, pour disposer les bandes conductrices (1) en forme d'hélice dans une structure porteuse tubulaire (5), celle-ci est formée en courbant une tôle (3) pour obtenir un tube et en reliant par un cordon de soudure (7) les bords de cette tôle (3).

4. Procédé selon la revendication 1, caractérisé en ce que la structure porteuse tubulaire (5) est recouverte sur sa surface interne d'un film de soudure, et qu'après le laminage ou l'étirage de la structure porteuse tubulaire (5) à son diamètre final, les bandes conductrices (1) sont soudées à cette structure porteuse tubulaire par échauffement.

5. Procédé selon la revendication 1, caractérisé en ce que les bandes conductrices (1), avant la réalisation de l'hélice, sont reliées à une bande métallique présentant de bonnes propriétés d'élasticité.

Fig 1

6

7

2

3

4

1

5

Fig 2

3

1

Fig 3

3

1

Fig 4

1

5

Fig 5

5

1

Fig 6

5

1